# EUROPÄISCHE PATENTSCHRIFT

(11) **EP 1 709 677 B1**
(45) Veröffentlichungstag und Bekanntmachung des Hinweises auf die Patenterteilung: **18.08.2010**
(21) Anmeldenummer: 05714911.4
(22) Anmeldetag: 31.01.2005
(51) Int. Cl.: H01L 21/762, H01L 21/763

(54) **PASSIVIERUNG TIEFER ISOLIERENDER TRENNGRAEBEN MIT VERSENKTEN ABDECKSCHICHTEN**
PASSIVATION OF DEEP ISOLATING SEPARATING TRENCHES WITH SUNK COVERING LAYERS
PASSIVATION DE PROFONDES TRANCHEES DE SEPARATION ISOLANTES PRESENTANT DES COUCHES DE REVETEMENT INTEGREES

(30) Priorität: 31.01.2004 DE 102004004942
(43) Veröffentlichungstag der Anmeldung: 11.10.2006
(73) Patentinhaber: X-FAB Semiconductor Foundries AG, 99097 Erfurt (DE)
(72) Erfinder: LERNER, Ralf, 99085 Erfurt (DE); ECKOLDT, Uwe, 99448 Hohenfelden (DE)
(74) Vertreter: Leonhard, Frank Reimund
(86) Internationale Anmeldenummer: PCT/DE2005/000145
(87) Internationale Veröffentlichungsnummer: WO 2005/074021

(56) Entgegenhaltungen:
- US-A- 4 795 721
- US-A- 5 440 166
- US-A- 5 581 110
- US-A1- 2002 072 198
- US-A1- 2002 076 874
- US-A1- 2002 119 639

## Beschreibung

Die Erfindung betrifft ein Verfahren zur Bearbeitung oder Behandlung von Halbleiterscheiben mit isolierenden Trenngräben, für eine Herstellung integrierter Halbleiterschaltungen, insbesondere mit dem Ziel der Verringerung der Verbiegung der Prozessscheiben, wodurch die Entstehung störender Kristallbaufehler im weiteren Prozessverlauf verhindert wird (Anspruch 1). Auch das product by process Produkt ohne Stufen in der Deckschicht ist beansprucht (Anspruch 26).

Zur Integration von Niederspannungs-Logikelementen und Hochspannungs-Leistungselementen in ein und demselben Siliziumschaltkreis ist es nötig, Chipbereiche mit unterschiedlichen Potentialen voneinander zu isolieren. Eine Möglichkeit dazu ist die sogenannte dielektrische Trenngrabenisolation (dielectric trench isolation). Dabei wird eine erste vertikal wirkende Isolation zwischen Bauelement und Substrat durch eine vergrabene isolierende Schicht realisiert (üblicherweise bestehend aus Siliziumdioxid: SiO₂, prinzipiell aber auch andere isolierende Schichten). Eine weitere lateral wirkende (vertikale) Isolation wird durch das Ätzen eines Grabens (Trench) bis auf die vergrabene isolierende Schicht einer SOl-Scheibe und ein anschließendes Wiederauffüllen dieses tiefen Grabens mit isolierenden Schichten (isolierender Trenngraben) erreicht. Dabei kann auch nur ein Teil oder lateraler Abschnitt des geätzten Grabens durch isolierendes Material aufgefüllt werden, das restliche Auffüllen des Grabens kann dann auch durch zumindest eine leitende Füllschicht (z.B. Polysilizium) erfolgen.

Durch sogenannte Planarisierungsschritte, z.B. geeignete Ätzverfahren oder chemisch mechanisches Polieren, wird eine Einebnung der Oberfläche erreicht.

Den repräsentativen Stand der Technik findet man z.B. in EP 1 184 902 A1 und EP 1 220 312 A1. Der Arbeitsschritt zur Herstellung des isolierenden Trenngrabens liegt mitten im Prozessablauf, es folgen also weitere Hochtemperaturschritte. Während des nachfolgenden weiteren Fertigungsprozesses werden auch Oxidationsschritte zur Erzeugung von thermischen Oxidschichten benötigt. Dabei kommt es jedoch auch zu einer Oxidation an den vertikalen Seitenwänden innerhalb des isolierenden Trenngrabens. Bei der üblichen Verwendung von Polysilizium als Füllschicht kommt es zusätzlich zu einer Oxidation des Polysiliziums an der Oberfläche, aber auch innerhalb des verfüllten isolierenden Trenngrabens.

Aufgrund des größeren spezifischen Volumens des entstehenden Siliziumdioxids gegenüber dem des Polysiliziums kommt es zu erheblichen Druckspannungen in den oberflächennahen Bereichen der verfüllten Trenngräben und damit zu einer Aufweitung der Trenngräben, bzw. zu einer Verbiegung der Siliziumscheiben und zur Entstehung von Kristalldefekten in den angrenzenden monokristallinen Siliziumbereichen. Die Kristalldefekte verschlechtern die Kenndaten der Bauelemente bzw. führen zu erhöhtem Ausschuss. Die Verbiegung wirkt sich negativ auf die Prozessierbarkeit der Halbleiterscheiben aus und führt auch darüber zu erhöhtem Ausschuss. Aus diesem Grund werden die Grabenbereiche mit einer sauerstoffundurchlässigen Schicht bzw. einem entsprechenden Schichtsystem abgedeckt, wie es aus US-A 5,933,746 bekannt ist.

Solche Abdeckungen sind auch in den Schriften US-A 5,581,110 (Razonk), US-A 200210025654, JP-A 2000-183156 und JP-A 63-003429 beschrieben.

Der Nachteil der so bekannten strukturierten Abdeckschichten liegt darin, dass diese über die planare Oberfläche hinausragen, was im weiteren Bearbeitungsprozess mit Nachteilen verbunden ist. Die Schichten bilden eine Stufe, die z.B. die Ausbildung von darüber hinwegführenden Leitbahnen stört, z.B. durch deren reduzierte Dicke an den Kanten. Die Abdeckschichten werden ferner durch einen zusätzlichen fotolithographischen Schritt definiert und anschließend geätzt, es muss also zum Einen eine Fotomaske erstellt und auf die Scheibe aufgebracht werden und es besteht zum Anderen die Gefahr einer seitlichen Fehljustierung der Fotomaske.

US 2002/0072198 A1 beschreibt ein Verfahren zur Bildung von 200 nm (2000 Å) bis 500 nm (5000 Å) tiefen Trenches in einem Siliziumsubstrat. Es handelt sich indes nicht um SOI-Halbleitermaterial und somit wird keine dielektrische Isolation von Niederspannungs-Logikelementen und Hochspannungs-Leistungselementen erreicht. Eine durchgängige planare Oberfläche ergibt sich aus dem dort beschriebenen Prozess ebenfalls nicht.

Es ist **Aufgabe der Erfindung**, eine Verfahrensweise für die Erzeugung von Isoliergräben in SOI-Halbleiterscheiben anzugeben, welche die Nachteile der über die planare Halbleiteroberfläche hinausragenden Abdeckung der Isoliergräben beseitigt und hinsichtlich einer Fotolithographie eine Vereinfachung des Verfahrensgangs ermöglicht. Außerdem ist eine Ausbeutesteigerung und eine Erhöhung der Zuverlässigkeit von integrierten Schaltkreisen, die neben Niederspannungs-Logikelementen auch Hochspannungs-Leistungselemente enthalten, zu beachten und zu erfüllen.

Die erfindungsgemäße Lösung schlägt ein Verfahren zur Herstellung einer Prozess-Scheibe vor (Anspruch 1), wobei die Herstellung die Behandlung oder Bearbeitung einer vorhandenen SOI-Scheibe ist, durch Einbringen von spezifisch ausgebildeten Trenngräben (Anspruch 26). Diese ermöglichen es, unterschiedliche Chipbereiche, welche in die aktive Halbleiterschicht eingebracht sind oder eingebracht werden, potentialmäßig besser zu trennen. Der eine Chipbereich kann auf einem Potential und der andere Chipbereich auf einem anderen Potential liegen, wobei diese Potentiale einen sehr hohen Unterschied als Spannung bzw. Potentialdifferenz aufweisen können, so dass Niederspannungs-Logikelemente in einem Bereich und Hochspannungs-Leistungselemente in einem benachbarten anderen Bereich vorgesehen sein können. Beide werden als "Elemente" (in halbleitertechnischer Hinsicht als "Bauelemente") angesprochen und hier nicht weiter erläutert, da sie nach gängigen Methoden des Standes der Technik hergestellt werden können.

Die dielektrische Trennung erfolgt durch isolierende Gebiete, welche zumindest einen Graben, bevorzugt aber eine Vielzahl von Gräben aufweisen, welche die Chipbereiche voneinander trennen. Ausgehend von einer planaren Oberfläche, von der herab sich die Gräben erstrecken, reichen sie bis zu einer horizontal liegenden vergrabenen Isolierschicht, die bei SOI-Wafern vorhanden ist. Die Trenngräben weisen zumindest ein oxidierendes Material auf, beispielsweise ein zur Verfüllung dienendes Polysilizium, welches bei sauerstoffhaltiger Atmosphäre und bei einer Temperatur oberhalb der Raumtemperatur oxidiert. Die sauerstoffhaltige Atmosphäre erhält durch eine erfindungsgemäß eingebrachte Decke, welche in den oberen Bereich des Grabens abgesenkt ist, keinen Zugang zu den (isolierenden) Bereichen der Grabenverfüllung. Trotz dieser Deckschicht kann die Oberfläche planar ausgestaltet werden, also sowohl oberhalb des Grabens wie auch daneben und lateral davon beabstandet in den zumindest sich randseitig des Grabens erstreckenden Bereichen bis hin über die gesamte Oberfläche der aktiven Halbleiterschicht des SOI-Wafers.

Wenn dabei - bei dem Herstellprozess - "Hauptarbeitsgänge" genannt sind, so ist das so zu verstehen, dass diese Arbeitsgänge hier in den Vordergrund gestellt werden, bezogen auf das Ziel und die hier beschriebene und beanspruchte Erfindung (Anspruch 1), gleichwohl sollen andere Arbeitsgänge, wie das Einbringen und Prozessieren der Niederspannungs-Elemente und Hochspannungs-Elemente oder das Ätzen der Grabenstruktur nicht ausgeschlossen werden.

Es sind folgende Hauptarbeitsvorgänge vorgesehen, wenn die Bearbeitung oder Behandlung der Halbleiterscheibe in einem zeitlichen Abschnitt ihres gesamten Prozessablaufs hier herausgestellt wird. Es wird dabei nur ein Trenngraben herausgestellt, obwohl in einer prozessierten Wafer-Scheibe eine Vielzahl solcher Trenngräben vorhanden sind, die mehrere Gebiete für Hochspannungs- und Niederspannungselemente voneinander elektrisch isolieren. Zumindest einer dieser Gräben ist Gegenstand der Umschreibung und Beanspruchung, wobei dieses ohne weiteres auch auf eine Vielzahl solcher Gräben erstreckt werden kann.

Zumindest einer der vorhandenen Trenngräben wird mit Isolierschichten versehen, welche vertikalen Isolierschichten in die Tiefe des Grabens herabreichen, bis hin zur horizontalen (vergrabenen) Isolierschicht. Gleichzeitig entsteht eine horizontale Isolierschicht auf der Oberseite der aktiven Halbleiterschicht.

Eine Verfüllsubstanz erhält eine tiefste Einsenkung, welche noch oberhalb über einem Niveau der horizontalen Isolierschichten gelegen ist. Es entsteht also auch ein horizontaler Abschnitt der abgeschiedenen Verfüllsubstanz, die nicht nur den Trenngraben auffüllt, sondern auch oberhalb der horizontalen Isolierschichten zu liegen kommt und hier eine Verfüllsubstanz-Schicht bildet. Insoweit kann auch allgemeiner von "Erzeugung von Isolierschichten" gesprochen werden, die horizontale und vertikale Anteile bzw. Flächenabschnitte besitzen. Beide werden durch das Füllen des zumindest einen Trenngrabens bedeckt.

In einem weiteren Verfahrensschritt wird eine Planarisierung dieser Verfüllsubstanz-Schicht vorgenommen. Dieses ist eine "erste Planarisierung". Anschließend erfolgt eine definierte Rückabtragung, insbesondere ein definiertes Zurückätzen (Rückätzen), welches die Verfüllsubstanz im Grabeninneren betrifft, also unterhalb der planaren Oberfläche, welche durch die horizontalen Abschnitte der Isolierschicht gebildet wird. Dieses Abtragen in den Graben hinein sorgt für eine Reduzierung der Füllhöhe des Grabens mit der oxidierungs-empfindlichen Verfüllsubstanz. Dieses Abtragen wird auch als ein Über-Abtragen bezeichnet, welches bis in eine "definierte erste Tiefe" des Grabens reicht, jedenfalls weit oberhalb des Grabenbodens und nur im oberen Abschnitt, bevorzugt oberhalb der Hälfte der Grabentiefe oder sogar weit oberhalb dieser hälftigen Tiefe (Anspruch 21, 22). Das Verfahren ist also für besonders tiefe Gräben geeignet (Anspruch 23, 24), die sich durch die gesamte aktive Halbleiterschicht bis zur vergrabenen Isolierschicht erstrecken, und nicht nur ein Stück weit in ein Halbleitersubstrat hinein. Damit kann Hochspannung von Niederspannung in unterschiedlichem Chipbereichen zuverlässig getrennt werden, bei einer Vermeidung von Oxidationseinflüssen an der Oberfläche des Grabens, wenn dieser Graben mit einem oxidations-empfindlichem Werkstoff gefüllt ist.

Um die für die Oxidationssperre vorgesehene Deckschicht in den Graben einzubringen bzw. unter die planare Oberfläche der aktiven Halbleiterschicht abzusenken, erfolgt ein Abtragen eines Stücks der Isolierschichten und ein weiteres Abtragen eines weiteren Stücks der Verfüllschicht.

Hier sind jeweils die vertikalen Anteile dieser Schichten betroffen oder gemeint, um ein annähernd gleiches Höhenniveau dieser Schichten im Trenngraben zu erhalten oder durch das zusätzliche Abtragen zu erreichen. Hinsichtlich der horizontalen Isolierschichten werden diese ebenfalls mit-abgetragen, so dass eine Oberfläche der aktiven Halbleiterschicht freiliegt. Dieses Über-Abtragen, insbesondere eine definierte Überätzung schafft im Graben einen oben am Grabenrand liegenden Raum zur Aufnahme einer nun einzubringenden Deckschicht, die als Schicht oder Schichtsystem nach dem Auftrag über das Niveau der planaren Oberfläche hinausragt, aber nach unten bis zum annähernd gleichen Höhenniveau im Graben reicht, gestützt von den übrigen vertikalen Schichten im Graben, einer Verfüllschicht und einer beidseitig liegende Rest-Isolierschicht.

Nach dem Auftragen dieser Abdeckschicht, die zunächst umfangreicher aufgetragen wird als später benötigt, erfolgt ein weiteres Planarisieren. Dieses weitere Planarisieren reduziert die Decke, als funktionelle Umschreibung einer Schicht oder eines Schichtsystems, durch planares Abtragen, wie mit einen mechanisch-chemischen Polierprozess oder durch einen Lackplanarisierungs-Prozess, um wiederum die Oberfläche der aktiven Halbleiterschicht freizulegen, den Graben nach oben oxid-hemmend abzudecken und dennoch eine umfangreich sich erstreckende planare Oberfläche zu schaffen, insbesondere im Bereich des und um den Graben herum, so dass keine Stufen entstehen, welche die Ausbildung von horizontalen Leiterbahnen erschweren würden.

Alle beschriebenen Prozessschritte werden ohne einen zusätzlichen photolithographischen Schritt ermöglicht; die einzige Photomaske, welche benötigt wird, wird zur Herstellung der Gräben, hier des zumindest einen umschriebenen Grabens eingesetzt. Neben dem Fortfall weiterer Photomasken ist es auch nicht mehr erforderlich, diese mehreren photolithographischen Prozesse aufeinander zu justieren, so dass seitliche Fehljustierungen von Photomasken entfallen. Oxidationen können im oberen Bereich des Grabens nicht mehr stattfinden, thermische Spannungen werden vermieden (Anspruch 6), jedenfalls deutlich reduziert. Weitere Hochtemperaturschritte können sich an die Herstellung der Grabenstruktur anschließen, ohne Gefahr des Auftretens von thermischen Spannungen als Folge von entstehenden Oxidationen im Graben-Oberbereich. Die Prozessierbarkeit der Scheibe wird verbessert, so dass auch die Ausbeute gesteigert werden kann.

Wenn mehrere Schichten als Schichtsystem eingesetzt werden, kann zumindest eine der mehreren Schichten besonders ausgebildet werden. Dabei kann zum einem eine Getterfähigkeit von Ionen beachtet werden, wie auch ein bestimmter Ausdehnungskoeffizient. Die abgesenkte Abdeckung des Trenngrabens erlaubt es, eine gegenseitige negative Beeinflussung von Schaltungsbereichen und Grabenbereichen auszuschließen, so das Vermeiden des Wanderns von Ionen. Eine Schichtkomponente kann auch zur Einstellung des Ausdehnungs-Koeffizienten des Gesamtsystems dienen (Anspruch 3, Anspruch 25).

Besonders vorteilhaft ist die Verwendung von Siliziumnitrid als sauerstoffundurchlässige Deckschicht (Anspruch 2).

Das durch das Verfahren hergestellte Produkt oder Zwischenprodukt als prozessierte Scheibe oder Prozessscheibe im Sinne einer zumindest teilweise bearbeiteten SOI-Halbleiterscheibe ist Gegenstand des Anspruchs 26. Hier werden die strukturellen Eigenschaften der durch Anspruch 1 geprägten Prozessscheibe als gegenständlicher Schutz beansprucht. Der Fachmann ist in der Lage, die Struktur der durch das Verfahren behandelten oder bearbeiten Wafer-Scheibe zu erkennen, so dass eine Umschreibung des Herstellprodukts an Hand eines Verfahrens möglich ist.

Die durchgehend flache Oberfläche bezieht sich auf die Deckschicht und die benachbarten Bereiche, die für Niederspannung und Hochspannung vorgesehene Chipbereiche sind (Anspruch 6). Die Ebene verläuft flach und bildet keine Stufen. Die in den Graben abgesenkte Deckschicht bildet auch eine lateral wirkende elektrische Isolation, die über die gesamte Grabenbreite hinweg reicht, ohne dass vertikale Isolierschichten an den Grabenwänden im Höhenbereich dieser Deckschicht beteiligt sind (Anspruch 12). Letztere Isolationen werden beispielsweise durch thermische Oxidation aufgebracht, und später hinsichtlich des horizontalen Anteils ganz abgetragen, hinsichtlich des vertikalen Anteils aber nur ein Stück weit, um für die abgesenkte Deckschicht Platz zu machen (Anspruch 9). Das Rückabtragen ist definiert und erfasst damit nur ein kleineres Stück der vertikalen Abschnitte (Anspruch 11) im Graben. Dennoch erfolgt das Abtragen im Graben auf der gesamten Grabenbreite zwischen den beiden Grabenwänden, welche von den benachbarten Abschnitten der aktiven Halbleiterschicht bestimmt sind (Anspruch 12).

Es versteht sich, dass die Deckschicht dielektrisch isolierend ist (Anspruch 13). Es versteht sich auch, dass die Deckschicht eine Oxidsperre für den darunter befindlichen Füllwerkstoff bildet. Diese Deckschicht wird ohne eine Maske hergestellt (Anspruch 10).

Eine dielektrische Isolierung mit Trenches (Trenngräben, Isoliergräben) wird zwar auch von der US-A 200310013272 (Hong) oder von der US-A 200310235975 (Tran) erreicht. Hier enden die Gräben bzw. deren Tiefe aber im homogenen Halbleitermaterial, und im Endstadium des Herstellungsprozesses wird eine dem Oberflächenniveau der Halbleiterscheibe entsprechende durchgängige planare Oberfläche meist nicht erreicht. In erster Schrift bleibt die freie Oberfläche von einer Doppelschicht bedeckt und ist nicht planar. In der zweitgenannten Schrift werden die Trenches zur Trennung von Gebieten verwendet, die unterschiedlich dotiert sind. Diese sind nicht für unterschiedliche Potentiale, wie Hochspannung und Niederspannung vorgesehen, bzw. zur Aufnahme von Leistungselementen und Logikelementen, so dass die Isoliergräben nach Abmessung und Ausführung nur sehr reduzierten Potentialdifferenzen standhalten müssen.

Die Erfindung anhand von Ausführungsbeispielen mit zwei Halbleiterscheiben unter Zuhilfenahme der Zeichnung erläutert und ergänzt.
- **Figur 1**: veranschaulicht einen Stand der Technik.
- **Figur 2**: zeigt ein Beispiel eines erfindungsgemäß abgedeckten Grabens.
- **Figur 3a**: bis
- **Figur 3f**: sind Stationen von Hauptverfahrensschritten einer Isoliergrabenherstellung mit einem planaren Abschluss der sauerstoffundurchlässigen Abdeckschicht, wie z.B. in Figur 2 dargestellt.
- **Figur 4**: ist eine im Größenmaßstab realisierte Grabenstruktur.

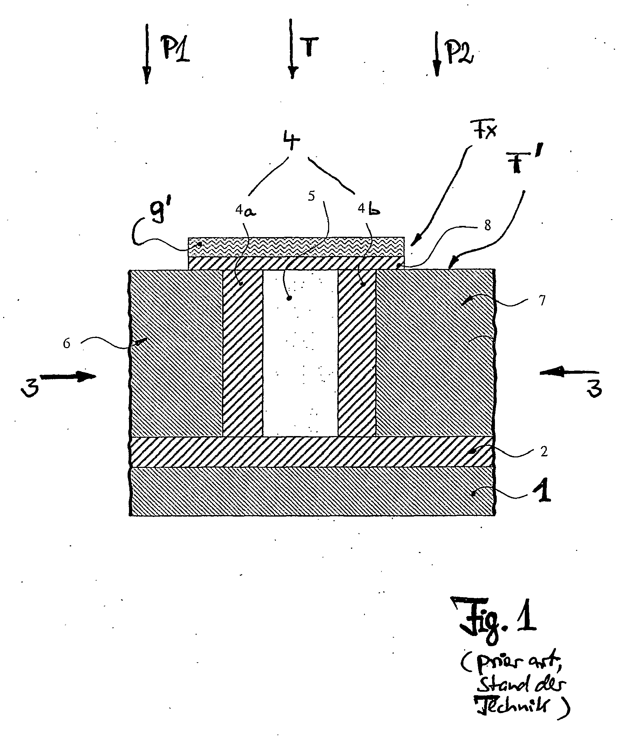

Figur 1 veranschaulicht einen Trenngraben im vertikalen Schnitt einer SOI-Scheibe, bei dem Abdeckschichten 8,9 vorgesehen sind. Die Abdeckschichten 8 und 9 liegen auf der planaren Oberfläche F' der aktiven Halbleiterschicht 3, wodurch eine nachteilige Stufe bei Fx entsteht. Der isolierende Trenngraben T trennt zwei Gebiete unterschiedlicher Potentiale, wobei diese Gebiete 6,7 dargestellt sind, aber die unterschiedlichen Potentiale erst in der Anwendung einer fertig prozessierten und zu Bauteilen vereinzelten Scheibe mit den zugehörigen Halbleiterelementen entsteht. Außer dem Graben T wird eine dielektrische Isolation von der vergrabenen isolierenden Schicht 2 und den beiden Isolierschichten 4a,4b, gemeinsam als "Isolierschichten 4" erreicht. Die planare Oberfläche F' der aktiven Halbleiterschicht hat in der abgedeckten Ausführung nach Figur 1 zumindest zwei laterale Stufen, wodurch die eingangs beschriebenen Nachteile entstehen.

Das SOI-Beispiel der Figur 1 zeigt zunächst eine Trägerschicht 1, eine darauf angeordnete Isolierschicht 2 und die aktive Halbleiterschicht 3, die hier bereits durch den Graben T mit seinen vertikalen Isolierschichten 4a,4b und einer Füllschicht 5 strukturiert ist. Dennoch soll diese Schicht 3 durchgehend als aktive Halbleiterschicht benannt werden, mit der vergrabenen Isolierschicht 2, die von den vertikalen Isolierabschnitten 4a,4b der Isolierschicht 4 erreicht wird.

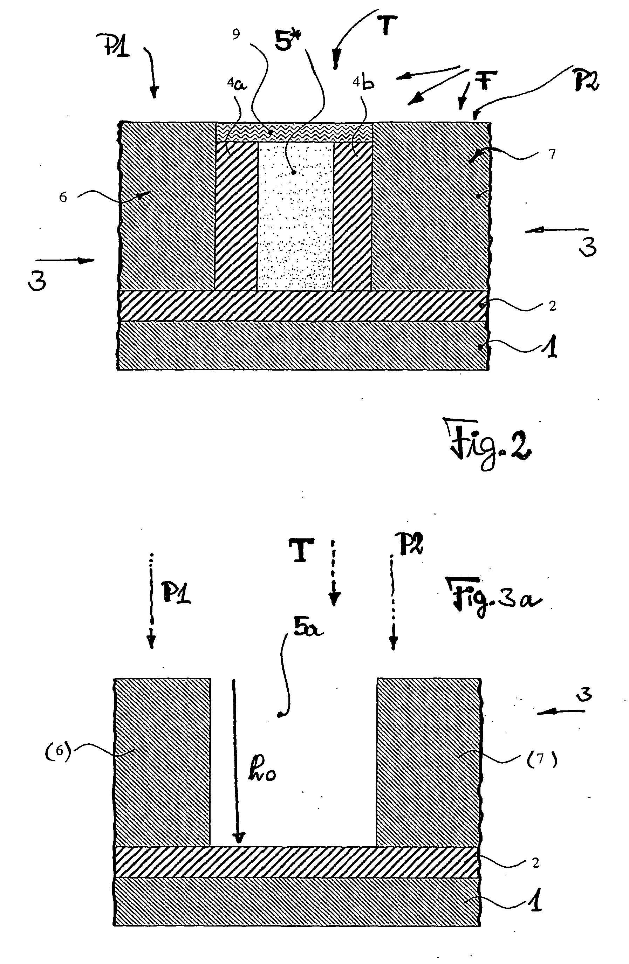

In **Figur 2** ist ein Beispiel einer neuen Grabenstruktur gezeigt. Hier ist die Deckschicht 9 so vorgesehen, dass sie mit der planaren Oberfläche F der Halbleiterscheibe eine Ebene bildet, d.h. es existiert keine Stufe oder Kerbe mehr. Insbesondere im Grabenbereich und daneben sind keine Stufen vorgesehen, da die Deckschicht 9 in den Graben abgesenkt ist. Gleiche Bezugszeichen bezeichnen gleiche Elemente, wobei im folgenden ein Herstellungsverfahren beschrieben wird, mit dem die Struktur nach Figur 2 erreicht wird.

In der Verwendung ist der eine Chipbereich 6 und der andere Chipbereich 7 mit Niederspannungs- bzw. Hochspannungselementen strukturiert, welche nach der hier beschriebenen Einbringung einer neuen Grabenstruktur entsteht, durch hier im einzelnen nicht dargelegte Prozessschritte von Halbleiterbauelementen, die aber als allgemein bekannt vorausgesetzt werden können. Es ist lediglich anzugeben, dass ein erstes Potential (P1) dem Chipbereich 6 und ein zweites Potential (P2) dem Chipbereich 7 zugeordnet sind. Diese Chipbereiche sind Abschnitte von der aktiven Halbleiterschicht 3, die bevorzugt aus Silizium ist.

Zu der früheren, gestuften, in Figur 1 dargestellten Grabenstruktur ist noch zu sagen, dass die Anordnung des Grabenbereichs T (T steht für "Trench") und der beiden Potentialbereiche P1 (Gebiet 6) und P2 (Gebiet 7) auch festgelegt wird, insoweit besteht kein Unterschied. Lediglich anzumerken ist, dass die gestufte Abdeckung im Stand der Technik mit einer Oxidschicht 8 arbeitet, die den Graben 5,4a,4b bzw. die darin enthaltenen Füllschichten abdeckt, und zusätzlich von einer Abdeckung 9' bedeckt ist, welche den isolierten Trenngraben zusätzlich bedeckt, z.B. aus Si3N4.

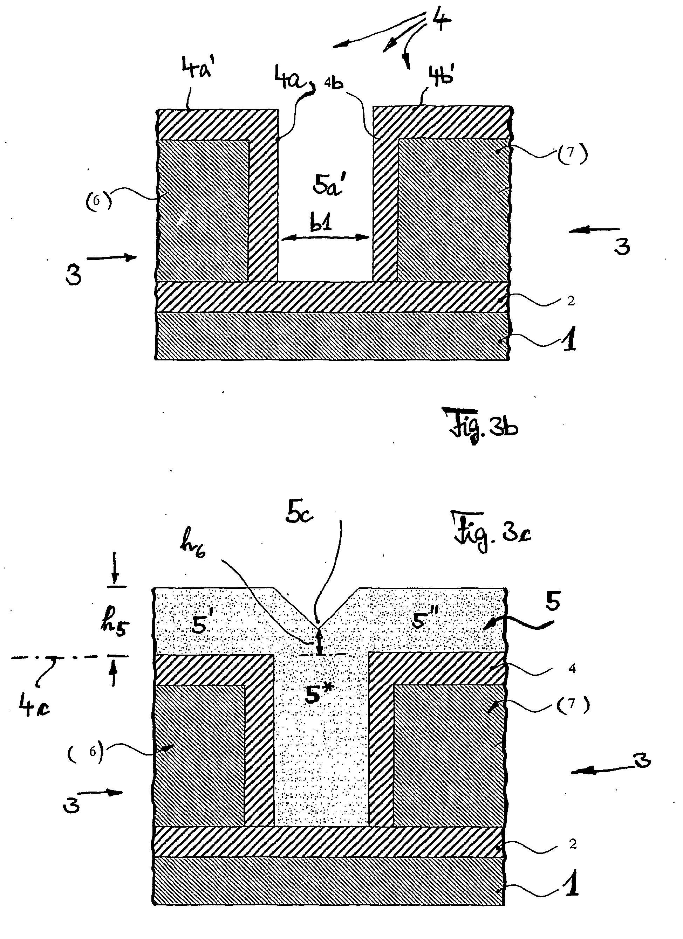

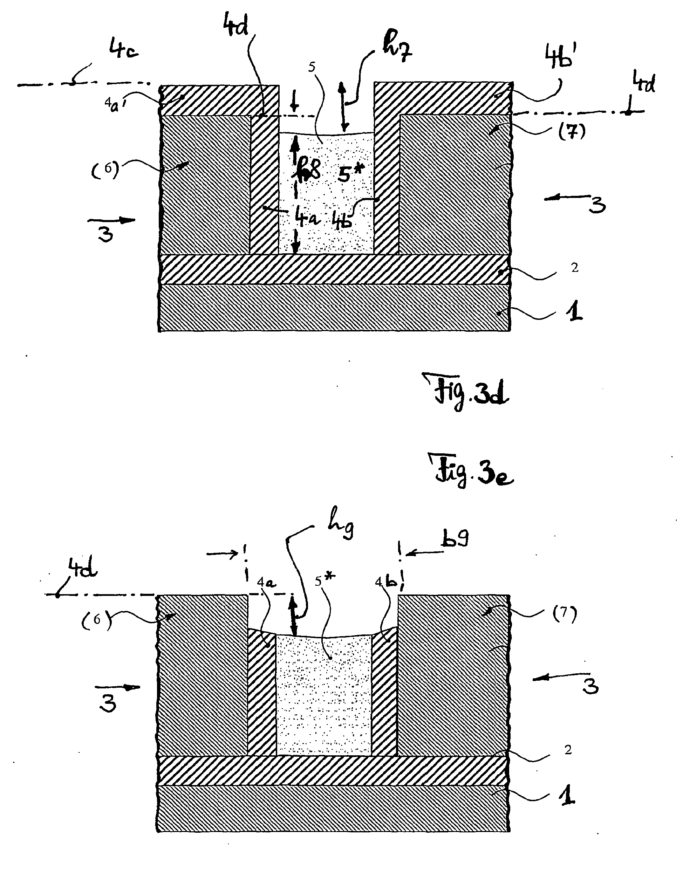

Kurz zusammengefasst soll ein bevorzugtes Verfahren anhand der Figurenreihe der **Figur 3a bis Figur 3f** veranschaulicht werden. Der durch Ätzung bis auf die vergrabene Isolierschicht 2 geschaffene Trenngraben gemäß Figur 3a, hier 5a benannt, wird mit Isolierschichten 4 versehen, z.B. durch eine thermische Oxidation. Es entsteht die Grabenstruktur gemäß Figur 3b. Nach Auffüllen des Grabens 5a', z.B. mit einem Polysilizium 5 über die planare Ebene 4c hinaus, unter Ausbildung einer Struktur nach Figur 3c, wird die Verfüllsubstanz 5 planarisiert und anschließend definiert rückgeätzt, wie Figur 3d zeigt.

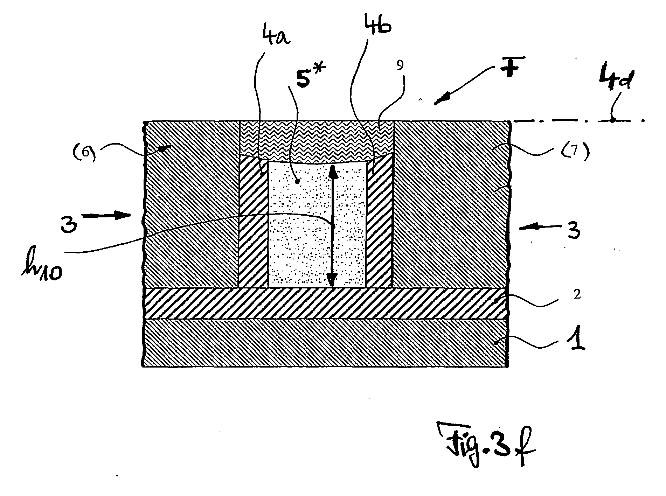

Dann folgt eine weitere Rückätzung der Isolierschichten 4 mit einer definierten Überätzung, so dass die beiden Schichten 4 und 5 in etwa gleiches Niveau haben, wie Figur 3e veranschaulicht. Anschließend wird die Abdeckschicht 9 aufgebracht und anschließend planarisiert, wie Figur 3f veranschaulicht. Das kann durch ein mechanisch-chemisches Polieren oder durch einen Lackplanarisierungs-Prozess geschehen, die bekannt und nicht dargestellt sind.

Das dargestellte Verfahren benötigt außer der Maske für den Trenngraben 5a, die hier nicht dargestellt ist, keine weiteren fotolithographischen Masken, um die Trenngraben-Abdeckung herzustellen.

Der isolierende Trenngraben kann auch so abgedeckt werden, dass eine gegenseitige negative Beeinflussung der Schaltungsbereiche und des Grabeninnern im weiteren technologischen Prozess ausgeschlossen werden kann, z.B. das Wandern von Ionen. Beim Erzeugen von Schichtsystemen mit entsprechenden Eigenschaften kann auch eine Schichtkomponente zur Einstellung des Ausdehnungs-Koeffizienten des Gesamtsystems dienen.

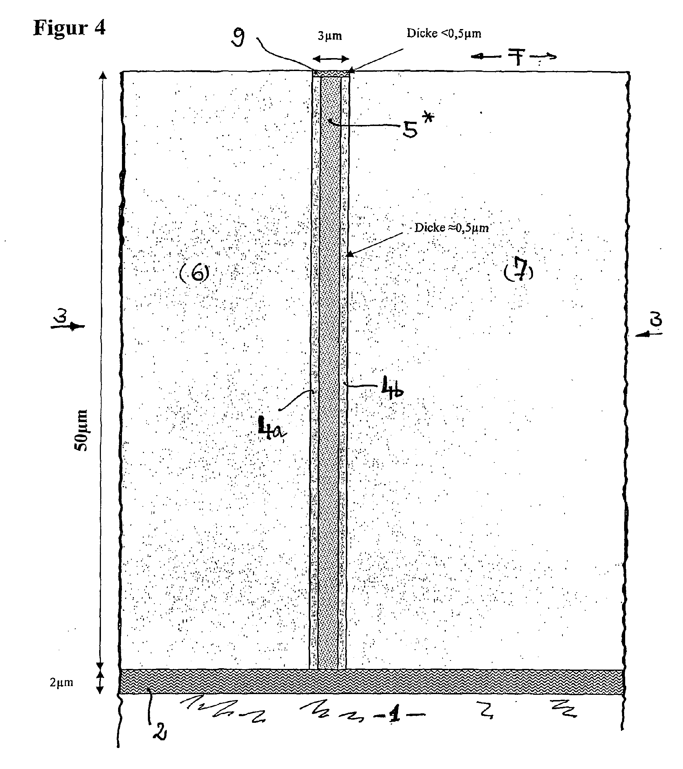

In einer detaillierten Ausführung wird einerseits das bisherige Verfahren erläutert und ergänzt. Die detaillierte Ausführung kann aber auch so betrachtet werden, dass sie als weiteres Ausführungsbeispiel von alternativen Verfahren angesehen wird, welche in der Lage sind, das Produkt nach Figur 2 herzustellen, dessen reale Größe und Gestalt die Figur 4 veranschaulicht.

Die mit einer ersten Maske hergestellte Grabenstruktur, von der ein Graben im Querschnitt dargestellt ist, ist als Maske nicht gesondert dargestellt, nur das Verfahrensergebnis. Der Graben 5a, der in Tiefenrichtung des Papiers längs verläuft, hat die Tiefe h0. Diese trennt den linken Bereich für beispielsweise hohes Potential P1 von dem rechten Bereich für beispielsweise niederes Potential P2. Der Trenchbereich T, welcher den Graben symbolisiert, schafft eine dielektrische Isolation, die im folgenden beschrieben wird. Unterhalb der Chipbereiche 6,7 am Ende der aktiven Halbleiterschicht 3 wird eine horizontal vergrabene Schicht 2 angenommen, die Folge der verwendeten Ausgangsscheibe ist, namentliche eine SOI-Scheibe, die zusätzlich noch eine Trägerschicht 1 besitzt. Die vergrabene Schicht 2 ist durch den Graben bereits ein Stück weit geöffnet, wird aber gemäß den folgenden Verfahrensschritten wieder dielektrisch isolierend geschlossen, um die Potentialdifferenz P1-P2 sperren zu können.

Isolierschichten 4 werden durch thermisch Oxidation nach Figur 3b aufgebracht, so dass der Graben 5a eine reduzierte Breite b1 erhält. Die vertikalen Abschnitte dieser Isolierschichten sind 4a und 4b, gegenüberliegend und an den Wänden des Grabens aufgebracht. Horizontale Abschnitte 4a' und 4b' gehören zu den Isolierschichten, die auf der freien aktiven Halbleiterschicht 3 aufgebracht werden, zusammen mit den vertikalen Schichtabschnitten. Es entsteht ein in der Breite reduzierter Graben 5a', der tiefer ist, weil die horizontalen Abschnitte 4a', 4b' etwas an vertikaler Höhe auf die Oberseite der aktiven Halbleiterschicht 3 auftragen.

Die beiden zu isolierenden Chipbereiche 6,7 sind durchweg in der gesamten Figurenfolge 3 unverändert.

Es folgt ein Verfahrensschritt zur Auffüllung des Grabens 5a'. Diese Auffüllung erfolgt so, das zumindest der eine Trenngraben mit einer Verfüllsubstanz gefüllt wird, wobei eine tiefste Einsenkung 5c einer an der Oberfläche gebildeten Verfüllsubstanz-Schicht 5',5" an ihrer Oberseite über einem Niveau 4c der durch die Isolierschichten 4 (deren horizontalen Abschnitten) gebildeten planaren Oberfläche zu liegen kommt. Die Einsenkung ist nicht maßstabgerecht und real dargestellt, sondern nur symbolisch. Ihr tiefstes Niveau 5c hat einen Höhenabstand h6 von der als Bezugsfläche verwendeten planaren Oberfläche 4c. Das Füllen des Trenngrabens mit der Verfüllsubstanz bildet einen ersten Abschnitt 5*, der auch vertikale Verfüllschicht genannt wird. Zwei horizontale Verfüllschichten mit derselben Verfüllsubstanz sind 5' und 5" benannt, diesseits und jenseits des Grabens bzw. oberhalb der diesseitigen horizontalen Isolierschicht 4a' oder der jenseitigen horizontalen Isolierschicht 4b'. Im Grabenbereich 5* hat die horizontale Verfüllschicht eine Einsenkung.

Die Dicke des horizontalen Abschnitts 5',5" der Verfüllsubstanzschicht 5 ist mit h5 benannt und etwas stärker als die Stärke der Isolierschichten 4.

Das Auffüllens des Grabens mit dem vertikalen Abschnitt 5* der Verfüllsubstanz erfolgt mit anderen Worten "über die planare Ebene 4c hinaus", was ein Auftragen der Verfüllsubstanz bedeutet. Diese Angabe, der Erstreckung über die Ebene 4c hinaus, ist durch die Ebene definiert, welche den Abstand h5 in Höhenrichtung besitzt. Dies bezieht sich auf Figur 3c.

In einem nicht dargestellten Zwischenschritt zur Figur 3d werden die horizontalen Abschnitte 5',5" der Verfüllsubstanz-Schicht planarisiert, also abgetragen, so dass die Isolationsschichten, respektive ihre horizontalen Abschnitte 4a',4b' wieder freigelegt werden. Dieses ist die erste Planarisierung.

Es geschieht ein anschließendes definiertes Rückabtragen, insbesondere in Form eines Rückätzens zum Erhalt der Grabenstruktur nach Figur 3d. Dieses Abtragen eines vertikalen Abschnitts der Verfüllsubstanz 5* betrifft ein Stück der Verfüllsubstanz im Grabeninnern und erreicht eine definierte Tiefe h7. Diese Tiefe reicht unter die vorher genannte Bezugsebene 4c, welche jetzt durch die freigelegte Oberseite der horizontalen Abschnitte der Isolierschicht 4 gebildet wird. Die Rückätzung der vertikalen Verfüllschicht erfolgt aber auch tiefer als eine zweite Bezugsebene 4d, welche durch die Oberseite der aktiven Halbleiterschicht 3 definiert wird.

Es entsteht ein Höhenniveau h8 im Graben 5a', welcher von der eingefüllten Verfüllsubstanz, insbesondere einem Polysilizium, eingenommen wird. Die erreichte rückgeätzte definierte Tiefe, wobei das Rückätzmaß mit h7 und das Restmaß mit h8 benannt ist, erreicht nur einen geringen Abschnitt der Tiefe des Grabens nach Figur 3d. Es ist nicht tiefer rückgeätzt als bis zur Hälfte der Grabentiefe, bevorzugt nur etwa % der Grabentiefe oder weit weniger, welches in anderen Ausführungsbeispielen erreicht werden kann.

Ein reales Maß veranschaulicht Figur 4.

Es folgt dann eine weitere Rückätzung der Isolierschichten 4, wobei hier die horizontalen Isolierschichten 4a', 4b' und ein Stück der vertikalen Isolierschichten 4a,4b betroffen sind. Mit dieser Rückätzung erfolgt auch eine definierte Überätzung der vertikalen Verfüllschicht 5', so dass im Ergebnis der Figur 3e die drei vertikalen Schichten 4a, 5* und 4b in etwa ein gleiches Höhenniveau besitzen. Diese Höhennivau erfolgt durch die Rückätzung um das Maß h9, bezogen auf die Oberfläche 4d der aktiven Halbleiterschicht 3. Die tatsächliche Rückätzung zum Erhalt der Figur 3e gegenüber der Figur 3d ist aber größer, nachdem die horizontalen Isolierschichten 4b' und 4a' ebenfalls abgetragen werden.

Abgetragen wird also ein Stück der Isolierschichten und ein Stück der vertikalen Verfüllschicht zur Erreichung und Bildung eines Aufnahmebereichs, der zwischen den Grabenwänden liegt und tiefer gelegen ist als die Oberfläche der aktiven Halbleiterschicht 3. Diese tritt nach Figur 3e freigelegt zutage.

Die geschaffene Öffnung hat eine Breite b9 und eine Tiefe h9, letztere bezogen auf die Oberfläche 4d. Das Aufbringen einer Deckschicht 9 füllt dieses tiefer gelegte Volumen auf und deckt gleichzeitig die Ebene 4d ab, so dass sie über das Niveau der planaren Oberfläche hinausragt. Das Hinausragen ist in vertikaler Richtung nach oben verstanden, gleichzeitig erstreckt sich die Deckschicht nach ihrer Abscheidung auf die Oberfläche 4d der aktiven Halbleiterschicht 3 auch nach unten, bis zum annähernd gleichen Höhenniveau im Grabenbereich. Letzteres entspricht dem Höhenniveau der Ebene 4d abzüglich h9.

Dieser Zwischenschritt ist nicht dargestellt. Dargestellt ist dann das Ergebnis des nächsten Zwischenschritts, bei dem ein abtragendes Planarisieren erfolgt, beispielweise durch eine mechanisch-chemische Polierung oder durch einen Prozess der Lackplanarisierung. Das diesbezügliche Verfahrensergebnis zeigt Figur 3f, wobei das beschriebene Volumen der Figur 3e mit einer Deckschicht 9 verfüllt ist, gleichzeitig aber die Oberfläche auf dem Niveau 4d eine durchgehende Fläche ergibt, welche mit F bezeichnet ist. Die aktive Halbleiterschicht 3 ist ebenfalls freigelegt. Die Trenngraben-Abdeckung 9 wird so ohne eine zusätzliche Maske erhalten. Sie sichert die Sperrung einer potentiellen Oxidation der Verfüllmasse 5* ab, kann gleichzeitig lateral isolieren, und erstreckt sich zwischen den beiden Grabenwänden, ohne Zwischenlage einer der beiden vertikalen Abschnitte 4a, 4b der Isolierschicht 4.

Nicht dargestellt sind mehrere Schichten als Schichtenfolge an der Stelle der Einzelschicht 9 nach Figur 3f. Hier können einzelne Schichten bestimmte Eigenschaften aufweisen, um Ausdehnungsverhalten oder Getterfähigkeit von Ionen zu beeinflussen.

Wird nur eine Schicht 9 vorgesehen, die eine "Decke" des Grabens bildet, kann sie aus Siliziumnitrid gestaltet sein. Sie ist nicht sauerstoff-durchlässig und elektrisch ausreichend isolierend.

Die Abstimmung aus Verfüllsubstanz 5* und Abdeckschicht 9 sorgt für das Vermeiden einer Verbiegung der Halbleiterscheibe im weiteren Prozess. Der obere Bereich des verfüllten Grabens kann nicht oxidieren, so dass auch keine unterschiedlichen Ausdehnungskoeffizienten entstehen. Die Abstimmung der vertikalen Isolierschichten, der Verfüllschicht und der Decke erfolgt zielgerichtet.

Trotz dieser erreichten Stabilität und Prozesssicherheit wird eine Oberfläche F erzielt, die keine Stufen aufweist. Dies betrifft insbesondere den Grabenbereich und die benachbarten Zonen.

Es stört nicht, wenn die Verfüllsubstanz 5* elektrisch leitfähig ist, nachdem die dielektrischen Isolierschichten 4a,4b vorgesehen sind. Es stört auch nicht, dass diese Verfüllschicht oxidationsfähig ist, weil die Deckschicht 9 insoweit eine Sperre gegen Oxidationen in folgenden Hochtemperatur-Schritten bietet.

Zur Tiefe der Abtragung war bislang bei einem Übergang von Figur 3c zur Figur 3d erwähnt worden, dass die Tiefe des Grabens nur ansatzweise erreicht wird und das abgetragene Stück der Tiefe h7 und h9 nur ein geringes Volumen der Verfüllsubstanz 5* erfasst. Dies ist Folge einer sehr tiefen Grabenstruktur, die für hohe Isolationsfestigkeit und eine relativ starke aktive Halbleiterschicht steht. Die Tiefe des Grabens und die Breite des Grabens kann in einem Aspektverhältnis zusammengefasst werden. Dieses Aspektverhältnis liegt oberhalb von 10:1 (Tiefe zu Breite), insbesondere oberhalb von 15:1. Mit anderen Worten handelt es sich um einen tiefen, schmalen Graben, was Figur 4 eindrucksvoll belegt.

In gleicher Weise war auch die Tiefe der zweiten Über-Ätzung zum Erhalt der Figur 3e bemessen. Hier wird auch nicht tiefer abgetragen als bis höchstens zur Hälfte der Grabentiefe, meist und bevorzugt aber viel früher, um die Stärke der Deckschicht nicht zu stark anwachsen zu lassen. Hier ist bevorzugt ein Maß von etwa ¼ der Grabentiefe oder weit weniger, bei Bemessung der Grabentiefe so, wie in Figur 3e oder Figur 4 dargestellt. Die Grabentiefe in der Figur 3d bemisst sich anders, nachdem hier nur horizontale Isolierschichten vorgesehen sind, die aber in ihrer Erstreckung keine zu großen Auswirkungen haben, nur zur Verdeutlichung übertrieben dargestellt sind.

Die Dicke der Schicht 9 kann kleiner 1 µm sein.

### Bezugszeichen

- 1:: Halbleiterscheibe (Substrat)
- 2:: vergrabene isolierende Schicht, z.B. SiO2
- 3:: bauelementetragende aktive Halbleiterschicht(en)
- 4:: isolierende Schicht, z.B. Si02 (als Schichtabschnitte 4a;4b)
- 5:: Füllschicht, z.B. Polysilizium, u.U. leitend
- 6:: aktiver Siliziumbereich auf Potential 1
- 7:: aktiver Siliziumbereich auf Potential 2
- 8:: Oxidschicht (Pad Oxid)
- 9:: Abdeckung des isolierenden Trenngrabens, z.B. Si₃N₄
- F:: Oberfläche (planare)

## Patentansprüche

1. **Verfahren zur Herstellung** einer Prozess-Scheibe für Schaltkreise, in denen Niederspannungs-Elemente und Hochspannungs-Elemente integriert sind, wobei Chipbereiche (6,7) unterschiedlicher Potentiale durch dielektrisch isolierende Gebiete (T) voneinander getrennt sind, indem von einer planaren Oberfläche (F) ausgehende Trenngräben vorgesehen werden, wobei zumindest einer davon im Grabenbereich ein unter sauerstoffhaltiger Atmosphäre bei erhöhter Temperatur oxidierendes Material erhält oder enthält, mit einer Abfolge von Hauptarbeitsgängen nach einer Erzeugung von zumindest zwei vertikalen Isolierschichten (4a,4b) und einer horizontalen Isolierschicht (4a',4b',4);
- Füllen des zumindest einen Trenngrabens mit einer Verfüllsubstanz (5,5*), bis eine tiefste Einsenkung (5c) einer an der Oberfläche gebildeten Verfüllsubstanzschicht (5',5") an ihrer Oberseite über einem Niveau der durch die Isolierschichten (4) gebildeten planaren Oberfläche zu liegen kommt;
- Planarisierung der Verfüllsubstanzschicht (5',5");
- Abtragen eines ersten Stücks der eingefüllten Verfüllsubstanz im Grabeninneren - als eine vertikale Verfüllschicht (5*) - durch ein erstes Überabtragen bis in eine definierte Tiefe (h7);
- Abtragen eines Stücks der Isolierschichten (4a,4b,4a',4b') und weiteres Überabtragen eines weiteren Stücks der vertikalen Verfüllschicht (5*), um ein annähernd gleiches Höhenniveau (h₁₀) der Schichten (4a,4b;5*) im Trenngraben zu erhalten oder zu erreichen;
- Abscheidung einer Abdeckschicht oder eines Schichtsystems als Decke (9) mit einer Dicke, welche über das Niveau der planaren Oberfläche (F) hinausragt und nach unten bis zum annähernd gleichen Höhenniveau (h₁₀) im Graben reicht;
- Planarisierung der Decke (9) durch ein mechanisch-chemisches Polieren oder einen Lackplanarisierungs-Prozess,
wobei die Decke (9) eine sauerstoff-un-durchlässige Abdeckung als Schichtsystem ist.

2. Verfahren nach Anspruch 1, wobei eine sauerstoffundurchlässige Decke (9) als eine Schicht aus Siliziumnitrid aufgetragen wird.

3. Verfahren nach Anspruch 1 oder 2, wobei die sauerstoffundurchlässige Decke zumindest eine Schicht mit einer anderen speziellen Eigenschaft aufweist, wie ein bestimmter Ausdehnungskoeffizient oder eine Getterfähigkeit von Ionen.

4. Verfahren nach Anspruch 1, wobei die Prozess-Scheibe eine SOI-Scheibe ist, mit einer vergrabenen Isolierschicht (2) auf einer Trägerschicht (1).

5. Verfahren nach Anspruch 1, wobei die Füllung (4,5*) des zumindest einen Trenngrabens (5a) mit der Decke (9) so abgestimmt sind, dass eine Verbiegung der Halbleiterscheibe bei der weiteren Prozessierung reduziert, insbesondere minimiert wird.

6. Verfahren nach Anspruch 1, wobei die Oberflächen der Decke (9) und freigelegter Chipbereiche (6,7) für Niederspannungs- und Hochspannungselemente eine durchgehende Ebene bilden (F), welche insbesondere keine Stufen im Grabenbereich (T) und daneben aufweist.

7. Verfahren nach Anspruch 1, wobei die Isolierschichten (4;4a,4b,4a',4b') durch eine thermische Oxidation aufgebracht werden.

8. Verfahren nach Anspruch 1, wobei die Verfüllsubstanz (5;5',5",5*) ein Polysilizium ist.

9. Verfahren nach Anspruch 1, wobei das gemeinsame Abtragen der Isolierschichten (4a,4b,4a',4b') und der vertikalen Verfüllschicht (5*) im definierten Ausmass einer Tiefenabtragung durch ein Ätzen erfolgt, insbesondere auf einer gesamten Grabenbreite (b9).

10. Verfahren nach Anspruch 1, wobei für die Verfahrensschritte nur eine Maske für die Herstellung des zumindest einen Trenngrabens (5a) verwendet wird.

11. Verfahren nach Anspruch 1, wobei das erste und das zweite Abtragen der vertikalen Verfüllschicht (5*) ein definiertes Rückätzen ist.

12. Verfahren nach Anspruch 1, wobei die in den Graben abgeschiedene Decke (9) eine vertikale oder lateral wirkende Isolation bildet, über eine gesamte Grabenbreite (b9) hinweg.

13. Verfahren nach Anspruch 1 oder 12, wobei die Decke (9) dielektrisch isolierend ist.

14. Verfahren nach Anspruch 1 oder 6, wobei die Niederspannungs-Elemente Logikelemente sind.

15. Verfahren nach Anspruch 1 oder 14, wobei die Hochspannungs-Elemente Leistungselemente sind.

16. Verfahren nach Anspruch 1 oder 14 oder 15, wobei die Elemente in einer aktiven Halbleiterschicht (3) gelegen sind, bzw. dort eingebracht werden.

17. Verfahren nach Anspruch 1 oder 16, wobei die aktive Halbleiterschicht (3) horizontal verläuft und in vertikaler Richtung unterseitig durch eine vergrabene Isolierschicht (2) begrenzt ist.

18. Verfahren nach Anspruch 1 oder 17, wobei zumindest ein Trenngraben (T,5a) in eine aktive Halbleiterschicht (3) bis zu deren unterem Ende an einer vergrabenen Isolierschicht (2) eingebracht wird.

19. Verfahren nach Anspruch 1, wobei die Verfüllsubstanz (5) elektrisch leitfähig ist, insbesondere ein Polysilizium, oder (leicht) oxidierfähig ist.

20. Verfahren nach Anspruch 1, wobei beim ersten Abtragen oder Überabtragen der vertikalen Verfüllschicht das Abtragen nicht tiefer (h7) als bis zur Hälfte der Grabentiefe erfolgt, insbesondere nur etwa 1/4 der Grabentiefe oder weniger beträgt.

21. Verfahren nach Anspruch 1 oder 20, wobei beim weiteren Abtragen oder Überabtragen nicht tiefer abgetragen wird (h9), als bis zur Hälfte der Grabentiefe, insbesondere nur etwa ¼ der Grabentiefe oder weniger.

22. Verfahren nach Anspruch 1, wobei die Grabentiefe (h0) des Trenngrabens (5a) in der aktiven Halbleiterschicht (3) größer als 1µm, insbesondere tiefer als 10µm oder im wesentlichen 50µm ist.

23. Verfahren nach Anspruch 1 oder 22, wobei der zumindest eine Trenngraben (5a) ein Aspektverhältnis von Tiefe zu Breite besitzt, welches oberhalb von 10:1, insbesondere oberhalb von etwa 15:1 gelegen ist.

24. Verfahren nach Anspruch 1 oder 18, wobei die vertikalen Isolierschichten (4a,4b) auf beiden Grabenwänden bis hinab zur horizontalen Isolierschicht (2) aufgebracht werden bzw. schon aufgebracht sind, wenn die Haupt-Arbeitsschritte des Anspruchs 1 beginnen.

25. Verfahren nach Anspruch 1, wobei die Decke (9) aus mehreren übereinander liegenden Schichten besteht.

26. **Prozessscheibe** mit Schaltkreisen, welche integrierte Niederspannungselemente und Hochspannungselemente aufweisen, wobei Chipbereiche (6,7) unterschiedlicher Potentiale durch dielektrisch isolierende Gebiete (T) voneinander getrennt sind, indem von einer planaren Oberfläche (F) ausgehende Trenngräben vorgesehen sind, wobei zumindest einer davon im Grabenbereich ein unter sauerstoffhaltiger Atmosphäre bei erhöhter Temperatur oxidierendes Material enthält, hergestellt mit einer Abfolge von Hauptarbeitsgängen nach einer Erzeugung von zumindest zwei vertikalen Isolierschichten (4a,4b) und einer horizontalen Isolierschicht (4;4a',4b') mit einem Verfahren zur Herstellung, umfassend
- ein Füllen des zumindest einen Trenngrabens mit einer Verfüllsubstanz (5), bis eine tiefste Einsenkung (5c) einer an der Oberfläche gebildeten Verfüllsubstanzschicht (5',5") an ihrer Oberseite über einem Niveau der durch die Isolierschichten (4) gebildeten planaren Oberfläche zu liegen kommt;
- erste Planarisierung der Verfüllsubstanzschicht (5',5");
- Abtragen eines ersten Stücks der eingefüllten Verfüllsubstanz im Grabeninneren - als eine vertikale Verfüllschicht (5*) - durch ein erstes Überabtragen bis in eine definierte Tiefe (h7);
- Abtragen eines Stücks der Isolierschichten (4a,4b,4a',4b') und weiteres Überabtragen eines weiteren Stücks der vertikalen Verfüllschicht (5*) für ein annähernd gleiches Höhenniveau (h₁₀) der Schichten (4a,4b;5) im Trenngraben (5a);
- Abscheidung einer Abdeckschicht oder eines Schichtsystems als Decke (9) mit einer Dicke, welche über das Niveau der planaren Oberfläche (F) hinausragt und nach unten bis zum annähernd gleichen Höhenniveau im Graben reicht;
- weitere Planarisierung der Decke (9) durch ein mechanisch-chemisches Polieren oder einen Lackplanarisierungs-Prozess,
wobei die Decke (9) eine sauerstoff-un-durchlässige Abdeckung als Schichtsystem ist.

## Claims

1. A method for producing a process wafer for (integrated) circuits, comprising integrated low voltage elements and high voltage elements, whereby chip regions (6, 7) of different potentials are separated from one another by dielectrically insulating regions (T) by providing isolation trenches extending from a planar surface (F), whereby at least one of them receives or comprises in the trench area a material that is oxidizing in an oxygen containing atmosphere at an elevated temperature, with a sequence of main process steps after production of at least two vertical insulating layers (4a, 4b) and a horizontal insulating layer (4a', 4b',4):
- filling said at least one isolation trench with a fill material (5,5*) until a deepest indentation (5c) of a fill material layer (5', 5") formed on the surface is positioned at its top side above a level of the planar surface being formed by the insulating layers (4);
- planarization of the fill material layer (5, 5");
- removing a first portion of the filled-in fill material in the interior of the trench - as a vertical fill layer (5*) - by a first over-removal process to a defined depth (h7);
- removing a portion of the insulating layers (4a, 4b, 4a', 4b') and further over-removing of a further portion of the vertical fill layer (5*) so as to obtain or reach an approximately equal height level (h₁₀) of the layers (4a, 4b; 5*) within said isolation trench;
- depositing a cap layer or a layer system as a cover (9) having a thickness extending above the level of the planar surface (F) and extending downwardly to the approximately equal height level (h₁₀) within the trench;
- planarization of the cover (9) by a mechanical-chemical polishing or a resist planarization process,
whereby the cover (9) is an oxygen-impermeable cap as layer system.

2. The method of claim 1, whereby an oxygen-impermeable cover (9) is deposited as a layer of silicon nitride.

3. The method of claims 1 or 2, whereby said oxygen-impermeable cover comprises at least one layer having a different specific characteristic, such as a specified coefficient of extension or a getter capability for ions.

4. The method of claim 1, whereby said process wafer is an SOI wafer with a buried insulating layer (2) on a carrier layer (1).

5. The method of claim 1, whereby the fill material (4, 5*) of said at least one isolation trench (5a) is adjusted with said cover (9) so that a bending of the semiconductor wafer is reduced, in particular minimized, during the further processing.

6. The method of claim 1, whereby the surfaces of the cover (9) and exposed chip regions (6, 7) form a continuous plane (F) for low voltage and high voltage elements, said plane in particular lacking steps in the trench area (T) and adjacent thereto.

7. The method of claim 1, whereby said insulating layers (4; 4a, 4b, 4a', 4b') are deposited by a thermal oxidation.

8. The method of claim 1, whereby said fill material (5; 5', 5", 5*) is a polysilicon.

9. The method of claim 1 whereby the concurrent removal of the insulating layers (4a, 4b, 4a', 4b') and the vertical fill layer (5*) is performed in a defined measure of a depth removal by an etching, in particular across an entire trench width (b9).

10. The method of claim 1, whereby only a mask for forming said at least one isolation trench (5a) is used for the process steps.

11. The method of claim 1, wherein the first and the second removal of the vertical fill layer (5*) is a defined etching-back.

12. The method of claim 1, whereby said cover (9) deposited into said trench forms a vertically or laterally acting insulation across an entire trench width (b9).

13. The method of claims 1 or 12, whereby said cover (9) is dielectrically insulating.

14. The method of claims 1 or 6, whereby said low voltage elements are logic elements.

15. The method of claims 1 or 14, whereby said high voltage elements are power elements.

16. The method of claims 1 or 14 or 15, whereby the elements are located in or are placed into an active semiconductor layer (3).

17. The method of claims 1 or 16, whereby said active semiconductor layer (3) extends horizontally and is bordered in the vertical direction on the lower side by a buried insulating layer (2).

18. The method of claims 1 or 17, whereby at least one isolation trench (T, 5a) is placed into an active semiconductor layer (3) to the lower end thereof at a buried insulating layer (2).

19. The method of claim 1, whereby said fill material (5) is electrically conductive, in particular is a polysilicon, or is (slightly) oxidizable.

20. The method of claim 1, whereby during the first removal or over-removal of the vertical fill material layer the removal is performed not deeper (h7) than to half of the trench depth, in particular only amounts to about 1/4 of the trench depth or less.

21. The method of claims 1 or 20, whereby during the further removal or over-removal material is removed not deeper (h9) than to half of the trench depth, in particular only to about 1/4 of the trench depth or less.

22. The method of claim 1, whereby said trench depth (h0) of the isolation trench (5a) in the active semiconductor layer (3) is greater than 1µm, in particular deeper than 10µm or is substantially 50µm.

23. The method of claims 1 or 22, whereby said at least one isolation trench (5a) has an aspect ratio of depth to width that is higher than 10:1, in particular higher than about 15:1.

24. The method of claims 1 or 18, whereby said vertical insulating layers (4a, 4b) at both trench walls are or have already been deposited down to the horizontal insulating layer (2), when the main process steps of claim 1 start.

25. The method of claim 1, whereby the cover (9) consists of several stacked layers.

26. Process wafer with (integrated) circuits, comprising integrated low voltage elements and high voltage elements, whereby chip regions (6, 7) of different potentials are separated from one another by dielectrically insulating regions (T) by providing isolation trenches extending from a planar surface (F), whereby at least one of them comprises in the trench area a material that is oxidizing in an oxygen containing atmosphere at an elevated temperature, produced with a sequence of main process steps, after a production of at least two vertical insulating layers (4a, 4b) and a horizontal insulation layer (4; 4a', 4b) with a method for producing, comprising:
- filling said at least one isolation trench with a fill material (5) until a deepest indentation (5c) of a fill material layer (5', 5") formed on the surface is positioned at its top side above a level of the planar surface being formed by the insulating layers (4);
- first planarization of the fill material layer (5',5");
- removing a first portion of the filled-in fill material in the interior of the trench - as a vertical fill layer (5*) - by a first over-removal process to a defined depth (h7);
- removing a portion of the insulating layers (4a, 4b, 4a', 4b') and further over-removing a further portion of the vertical fill layer (5*) for an approximately equal height level (h₁₀) of the layers (4a,4b;5) within said isolation trench (5a);
- depositing a cap layer or a layer system as a cover (9) having a thickness extending above the level of the planar surface (F) and extending downwardly to the approximately equal height level within the trench;
- further planarization of the cover (9) by a mechanical-chemical polishing or a resist planarization process,
whereby the cover (9) is an oxygen-impermeable cap as layer system.

## Revendications

1. Procédé de fabrication d'une galette opérationnelle pour des circuits de commutation, dans lesquels sont intégrés des éléments basse tension et des éléments haute tension, dans lequel des plages de puce (6, 7) à des potentiels différents sont séparées les unes des autres par des zones diélectriques isolantes (T) en ce qu'il est prévu des tranchées de séparation partant d'une surface plane (F), dans lequel au moins une de celles-ci reçoit ou contient, dans la région de la tranchée, un matériau s'oxydant à une température accrue sous une atmosphère contenant de l'oxygène, avec une succession d'opérations principales après une production d'au moins deux couches isolantes verticales (4a, 4b) et d'une couche isolante horizontale (4a', 4b', 4):
- remplissage de ladite au moins une tranchée de séparation avec une substance de remplissage (5, 5*), jusqu'à ce qu'un creux le plus profond (5c) d'une couche de substance de remplissage (5', 5") formée sur la surface vienne se situer sur son côté supérieur au-dessus du niveau de la surface plane formée par les couches isolantes (4);
- planage de la couche de substance de remplissage (5', 5"),
- enlèvement d'une première portion de la substance de remplissage déversée à l'intérieur de la tranchée - sous la forme d'une couche de remplissage verticale (5*) - par un premier creusement jusqu'à une profondeur définie (h7);
- enlèvement d'une portion des couches isolantes (4a, 4b, 4a', 4b') et à nouveau creusement d'une autre portion de la couche de remplissage verticale (5*), afin de réaliser ou d'atteindre un niveau de hauteur approximativement identique (h₁₀) des couches (4a, 4b; 5*) dans la tranchée de séparation;
- dépôt d'une couche de recouvrement ou d'un système de couches comme recouvrement (9) avec une épaisseur, qui s'élève au-delà du niveau de la surface plane (F) et qui descend dans le bas jusqu'au niveau de hauteur approximativement identique (h₁₀) dans la tranchée;
- planage du recouvrement (9) par un polissage mécanique-chimique ou par un procédé de planage à la laque,
dans lequel le recouvrement (9) est un recouvrement imperméable à l'oxygène sous la forme d'un système de couches.

2. Procédé selon la revendication 1, dans lequel on dépose un recouvrement imperméable à l'oxygène (9) sous la forme d'une couche de nitrure de silicium.

3. Procédé selon la revendication 1 ou 2, dans lequel le recouvrement imperméable à l'oxygène comprend au moins une couche présentant une autre propriété spéciale, comme un coefficient de dilatation déterminé ou une capacité de sorption d'ions.

4. Procédé selon la revendication 1, dans lequel la galette opérationnelle est une galette SOI, avec une couche isolante enfouie (2) sur une couche de support (1).

5. Procédé selon la revendication 1, dans lequel le remplissage (4, 5*) de ladite au moins une tranchée de séparation (5a) est accordé avec le recouvrement (9), de telle manière qu'une courbure de la galette de semi-conducteur lors des traitements ultérieurs soit réduite, en particulier minimisée.

6. Procédé selon la revendication 1, dans lequel les surfaces du recouvrement (9) et des zones de puce libérées (6, 7) forment, pour des éléments basse tension et haute tension, un plan continu (F), qui ne présente en particulier pas de gradins dans la région de la tranchée (T) et à côté de celle-ci.

7. Procédé selon la revendication 1, dans lequel les couches isolantes (4; 4a, 4b, 4a', 4b') sont appliquées par une oxydation thermique.

8. Procédé selon la revendication 1, dans lequel la substance de remplissage (5; 5', 5", 5*) est un polysilicium.

9. Procédé selon la revendication 1, dans lequel l'enlèvement commun des couches isolantes (4a, 4b, 4a', 4b') et de la couche de remplissage verticale (5*) dans la mesure définie d'un enlèvement en profondeur est effectué par une attaque à l'acide, en particulier sur une largeur de tranchée totale (b9).

10. Procédé selon la revendication 1, dans lequel on n'utilise, pour les étapes du procédé, qu'un seul masque pour la réalisation de ladite au moins une tranchée de séparation (5a).

11. Procédé selon la revendication 1, dans lequel le premier et le deuxième enlèvement de la couche de remplissage verticale (5*) est une gravure en retrait définie.

12. Procédé selon la revendication 1, dans lequel le recouvrement (9) déposé dans la tranchée forme une isolation agissant verticalement ou latéralement, sur une largeur de tranchée totale (b9).

13. Procédé selon la revendication 1 ou 12, dans lequel le recouvrement (9) est isolant et diélectrique.

14. Procédé selon la revendication 1 ou 6, dans lequel les éléments basse tension sont des éléments logiques.

15. Procédé selon la revendication 1 ou 14, dans lequel les éléments haute tension sont des éléments de puissance.

16. Procédé selon la revendication 1 ou 14 ou 15, dans lequel les éléments sont situés dans une couche de semi-conducteur active (3), ou sont incorporés dans celle-ci.

17. Procédé selon la revendication 1 ou 16, dans lequel la couche de semi-conducteur active (3) s'étend horizontalement et est limitée en direction verticale, du côté inférieur, par une couche isolante enfouie (2).

18. Procédé selon la revendication 1 ou 17, dans lequel au moins une tranchée de séparation (T, 5a) est introduite dans une couche de semi-conducteur active (3), jusqu'à l'extrémité inférieure de celle-ci sur une couche isolante enfouie (2).

19. Procédé selon la revendication 1, dans lequel la substance de remplissage (5) est électriquement conductrice, en particulier un polysilicium, ou (légèrement) oxydable.

20. Procédé selon la revendication 1, dans lequel, lors du premier enlèvement ou creusement de la couche de remplissage verticale, l'enlèvement n'est pas effectué plus profondément (h7) que jusqu'à la moitié de la profondeur de la tranchée, en particulier ne vaut qu'environ 1/4 de la profondeur de la tranchée, ou moins encore.

21. Procédé selon la revendication 1 ou 20, dans lequel, lors de l'enlèvement ou du creusement ultérieur, l'enlèvement n'est pas effectué plus profondément (h9) que jusqu'à la moitié de la profondeur de la tranchée, en particulier seulement jusqu'à environ 1/4 de la profondeur de la tranchée, ou moins encore.

22. Procédé selon la revendication 1, dans lequel la profondeur de tranchée (h0) de la tranchée de séparation (5a) dans la couche de semi-conducteur active (3) est supérieure à 1 µm, en particulier supérieure à 10 µm ou vaut essentiellement 50 µm.

23. Procédé selon la revendication 1 ou 22, dans lequel ladite au moins une tranchée de séparation (5a) possède un rapport de forme de la profondeur à la largeur, qui est supérieur à 10: 1, en particulier supérieur à environ 15:1.

24. Procédé selon la revendication 1 ou 18, dans lequel les couches isolantes verticales (4a, 4b) sont ou ont déjà été déposées sur les deux flancs de la tranchée, jusqu'à la couche isolante horizontale (2), lorsque les opérations principales de la revendication 1 commencent.

25. Procédé selon la revendication 1, dans lequel le recouvrement (9) se compose de plusieurs couches superposées.

26. Galette opérationnelle avec des circuits de commutation, qui comprennent des éléments basse tension et des éléments haute tension intégrés, dans laquelle des plages de puce (6, 7) à des potentiels différents sont séparées les unes des autres par des zones diélectriques isolantes (T) en ce qu'il est prévu des tranchées de séparation partant d'une surface plane (F), dans laquelle au moins une de celles-ci reçoit ou contient, dans la région de la tranchée, un matériau s'oxydant à une température accrue sous une atmosphère contenant de l'oxygène, fabriquée avec une succession d'opérations principales après une production d'au moins deux couches isolantes verticales (4a, 4b) et d'une couche isolante horizontale (4; 4a', 4b') avec un procédé de fabrication comprenant:
- un remplissage de ladite au moins une tranchée de séparation avec une substance de remplissage (5), jusqu'à ce qu'un creux le plus profond (5c) d'une couche de substance de remplissage (5', 5") formée sur la surface vienne se situer sur son côté supérieur au-dessus du niveau de la surface plane formée par les couches isolantes (4);
- un premier planage de la couche de substance de remplissage (5', 5"),
- un enlèvement d'une première portion de la substance de remplissage déversée à l'intérieur de la tranchée - sous la forme d'une couche de remplissage verticale (5*) - par un premier creusement jusqu'à une profondeur définie (h7);
- un enlèvement d'une portion des couches isolantes (4a, 4b, 4a', 4b') et à nouveau un creusement d'une autre portion de la couche de remplissage verticale (5*), pour un niveau de hauteur approximativement identique (h₁₀) des couches (4a, 4b; 5) dans la tranchée de séparation (5a);
- un dépôt d'une couche de recouvrement ou d'un système de couches comme recouvrement (9) avec une épaisseur, qui s'élève au-delà du niveau de la surface plane (F) et qui descend dans le bas jusqu'au niveau de hauteur approximativement identique dans la tranchée;
- un autre planage du recouvrement (9) par un polissage mécanique-chimique ou par un procédé de planage à la laque,
dans lequel le recouvrement (9) est un recouvrement imperméable à l'oxygène sous la forme d'un système de couches.
